# EUROPEAN PATENT SPECIFICATION

(11) **EP 0 288 186 B1**
(45) Date of publication and mention of the grant of the patent: **30.06.1993**
(21) Application number: 88303160.1
(22) Date of filing: 08.04.1988
(51) Int. Cl.: H01L 25/04, H01L 23/32

(54) **Packaging of semiconductor integrated circuits**
Verpackung von integrierten Halbleiterschaltungen
Empaquetage de circuits intégrés semi-conducteurs

(30) Priority: 22.04.1987 JP 97331/87; 22.04.1987 JP 97329/87; 22.04.1987 JP 97330/87; 22.04.1987 JP 97326/87; 24.04.1987 JP 99779/87
(43) Date of publication of application: 26.10.1988
(60) Divisional application: 92112517.5
(73) Proprietor: HITACHI, LTD., Chiyoda-ku, Tokyo 101 (JP)
(72) Inventor: Tazunoki, Masanori, Midorigaoka 2-chome Nishitama-gun Tokyo (JP); Mishimagi, Hiromitsu No. 105, Sharumankohpohaijima, Akishima-shi Tokyo (JP); Homma, Makoto, Nishitama-gun Tokyo (JP); Sakuta, Toshiyuki, Midorigaoka 2-chome Nishitama-gun Tokyo (JP); Nakamura, Hisashi, Ohme-shi Tokyo (JP); Sasaki, Keiji, Musashino-shi Tokyo (JP); Enomoto, Minoru, Tokorozawa-shi Saitama (JP); Satoh, Toshihiko, Sayama-shi Saitama (JP); Sahara, Kunizo, Midorigaoka 2-chome Nishitama-gun Tokyo (JP); Kuroda, Shigeo, Ohme-shi Tokyo (JP); Otsuka, Kanji, Higashiyamato-shi Tokyo (JP); Kawamura, Masao, Fuchu-shi Tokyo (JP); Kurosawa, Hinoko, Hino-shi Tokyo (JP); Ito, Kazuya, Kodaira-shi Tokyo (JP)
(74) Representative: Calderbank, Thomas Roger

(56) References cited:
- FR-A- 2 344 964
- US-A- 3 908 155
- IBM TECHNICAL DISCLOSURE BULLETIN, vol. 17, no. 4, September 1974, pages 987-988, New York, US; H.F. TEPPER: "Packing for a large memory system"
- IDEM
- IEEE TRANSACTIONS ON COMPONENTS, HYBRIDS AND MANUFACTURING TECHNOLOGY, vol. CHMT-5, no. 1, March 1982, pages 171-180, New York, US; T.R. ANTHONY: "Forming feedthroughs in laser-drilled holes in semiconductor wafers by double-sputtering"
- IDEM
- PATENT ABSTRACTS OF JAPAN, vol. 11, no. 117 (E-498)[2564], 11th April 1987; & JP-A-61 263 161

## Description

The present invention relates to the packaging of semiconductor integrated circuits according to claim 1, and more particularly to a packaging technique for semiconductor integrated circuits formed on a large-sized semiconductor substrate such as a semiconductor wafer.

In general, semiconductor integrated circuits are constructed on respective parts of a substate, i.e. a semiconductor wafer chip the wafer then being subdivided by dicing it into a plurality of parts each corresponding to one or more integrated circuits. However, recently, constructions have been investigated in which the semiconductor wafer is not subdivided, but a plurality of integrated circuits are fabricated on the whole of the semiconductor wafer so as to construct a large-sized semiconductor integrated circuit. Such a semiconductor manufacturing technique is described in e.g. JP-A-61/290739, in which one large-sized semiconductor integrated circuit is constructed on the entire semiconductor wafer.

There is, however, no known method of packaging a stack of large-sized semiconductor wafers where the connections to each wafer are independent of the connections to the other wafers.

US-A-3 908 155 discloses a device for packaging a stack of wafers interconnected by a common interconnection bus. Similarly, the disclosure contained in the IBM Technical Disclosure Bulletin, vol. 17, no. 4, September 1974: "Packaging for large memory system", by H. F. Tepper, describes a packaging device where the interconnections to the wafers extend from common interconnection tabs.

The present invention therefore proposes a stack of large sized semiconductor substrates, comprising a packaging device with a plurality of engaging means, each engaging means being for engaging a respective one of the substrates to maintain the substrates in spaced apart relationship, characterised in that:
the engaging means including means for providing a plurality of independent electrical connections to the substrate.

The engaging means may be a plurality of interconnected pillars each having means for engaging the substrates at the periphery of those substrates. This has the advantage that the wafer(s) are supported at a plurality of positions, so that the wafer(s) cannot vibrate or twist. The pillars may then be hingedly interconnected to the base, possibly via springs which holds them into engagement with the wafers.

Thus, the present invention may provide a stack of large-sized semiconductor substrates, comprising a packaging device engaging the substrates to maintain them in a spaced apart relationship.

The wafer(s) may then be electrically connected to the packaging device, e.g. by spring electrodes.

Embodiments of the present invention will now be described in detail,by way of example, with reference to the accompanying drawings, in which:
Fig. 1A is a perspective view of an entire packaging device for supporting a plurality of large-sized semiconductor substrates constructed of a semiconductor wafer;
Fig. 1B is an enlarged perspective view of a supporting member employed in the packaging device shown in Fig. 1A;
Fig. 1C is a side view of the supporting member;
Fig. 1D is a side view of the modified supporting member;
Fig. 2A is a perspective view of an entire packaging device;
Figs. 2B and 2C are side views of a semiconductor substrate supporting member;
Fig. 2D is a perspective view of a pillar connecting substrate 2, which is observed from its bottom side;
Fig. 2E is a perspective view of a connection part between the pillar and the pillar connecting substrate;
Fig. 2F is a perspective view of a modified packaging device;
Fig. 3A is a plan view of a mounting substrate on which a plurality of semiconductor chips are mounted;

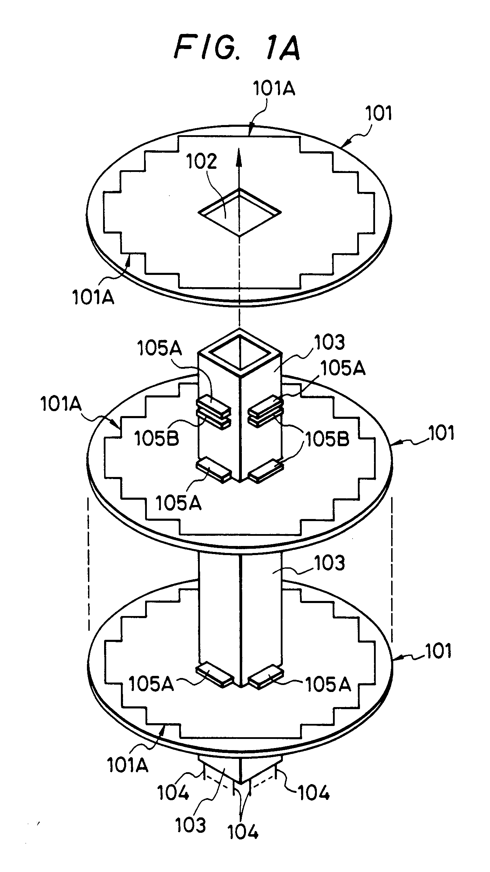

In a semiconductor integrated circuit according to a first embodiment of the present invention, as illustrated in Fig. 1A, an integrated circuit region 101A on which various integrated circuits have been constructed, is present on a surface of a large-sized semiconductor substrate 101 made of a semiconductor wafer. At a central portion of the above-described semiconductor substrate 101, a rectangular opening 102 which has been formed by, for instance, etching treatment, is formed. The semiconductor substrate 101 is supported by an upper supporting member 105A and a lower supporting member 105B made of, e.g., an epoxy resin in such a manner that, a rectangular pillar 103 made of, for instance, an alminium alloy or a plastic resin is pierced through the opening 102, and the substrate is sandwiched by both the upper and lower supporting members 105A and 105B formed on the four sides of the pillar 103. The central portion of this pillar 103 is made empty. A size of the opening 102 of the substrate 101 is defined under the condition that the pillar 103 can be substantially penetrated through the opening 102 while both the upper and lower supporting members 105A and 105B are bent toward the pillar side. It should be noted that if the pillar 103 is made of a metal such as aluminium, the surface of the metal pillar is covered with a resin so as to electrically insulate the wiring leads. A plurality of connector pins 104 are formed on the bottom of the pillar 103 so as to package the pillar 103 which mounts a plurality of semiconductor substrates 101, on a packaging substrate (not shown).

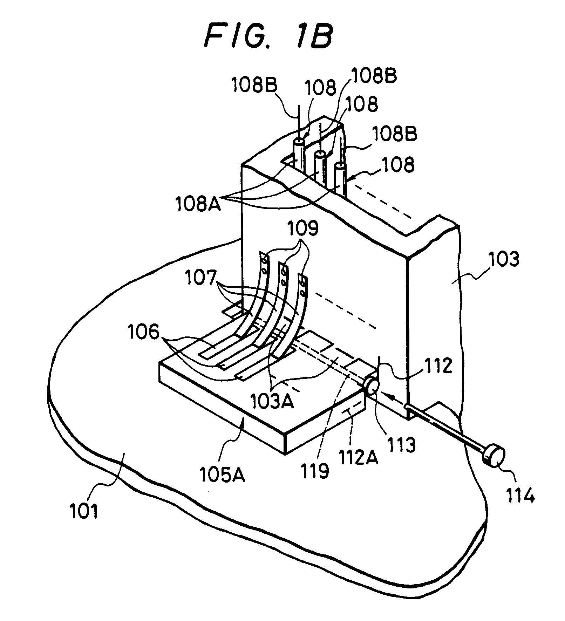

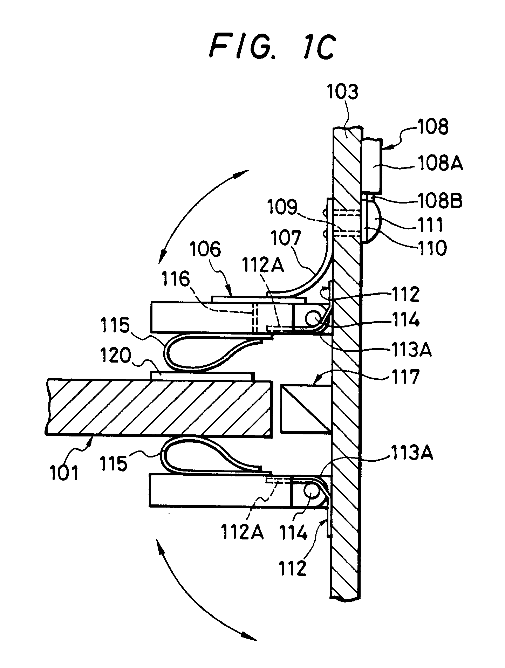

Both the upper and lower supporting members 105A and 105B have such a shape that, as illustrated in Figs. 1B and 1C, each edge thereof located at the pillar 103 is engaged with a supporting projection 103A which projects from the pillar 103. A hole 119 for penetrating a supporting shaft 114 therethrough is formed on the upper supporting member 105A, lower supporting member 105B, and supporting projection 103A, respectively. That is to say, both the upper and lower supporting members 105A and 105B are mounted on the supporting projection 103A in such a manner that they can be rotated with respect to the supporting axis 114 as its rotating center. To sandwich the semiconductor substrate 101 by the upper and lower supporting members 105A and 105B, a twist coil spring 112 is arranged on both sides of the upper and lower supporting members 105A and 105B, one end 112A of the twist coil spring 112 is fixed to either the upper supporting member 105A or lower supporting member 105B, and the supporting shaft 114 is penetrated through a central hole 113 thereof. It is seen that only twist coil spring 112 of one edge of the respective upper and lower supporting members 105A and 105B in Figs. 1B and 1C. As a result, the semiconductor substrate 101 is supported by the upper and lower supporting members 105A and 105B by means of the elasticity of the above-described twist coil spring 112.

A plurality of fixing electrodes are fixed on the upper surface of the upper supporting member 105A, which are made of aluminium on which, for instance, copper or silver is plated. A plurality of brush electrodes having elasticity are provided on the side of the pillar 103 corresponding to the fixing electrodes 106, and one end of the respective brush electrodes is resiliently in contact with the surface of the corresponding fixing electrodes 106. The end portion of the respective brush electrodes 107 which is resiliently in contact with the respective fixing electrodes, is slidable on the corresponding fixing electrode 106 while the upper supporting members 105A is rotated. Another electrode 110 made of, for example, cupper is provided on an inner surface of the pillar 103, in relation to the above-described brush electrode 107, and is connected to the brush electrode 107 by a lead 109 made of, for instance, aluminium on which silver is plated. Between this lead 109 and the pillar 103, an epoxy resin is provided for electrical insulation. A core 108B of an electrically insulated cable 108, the surface of which is covered with an insulating film 108A such as a resin, vinyl chloride, is connected to the corresponding electrode 110 by, for example,solder 111. The insulated cable 108 is attached to the pillar 103 by adhesive agent so that these insulated cables are employed to connect between the respective semiconductor substrates 101 provided on the pillar 103 and also the semiconductor substrate 101 and the connector pin 104 shown in Fig. 1A.

A spring electrode 115 having elasticity is provided on the upper surface corresponding to the respective fixing electrodes 106 of the upper supporting member 105A. A pin 116 made of, for example, silver-plated aluminium is mechanically and electrically connected between the spring electrode and the fixing electrode 106. The respective spring electrodes 115 are resiliently in contact with an electrode 120 made of, for example, an aluminium film which is provided on the surface of the semiconductor substrate 101. Also, a spring electrode 115 is provided on the lower supporting member 105B in order that it is used as a supporting member for sandwiching the semiconductor substrate 101. That is to say, the semiconductor substrate 101 is supported in such a manner that a plurality of spring electrodes 115 respectively provided on the upper and lower supporting members 105A and 105B sandwich this substrate 101.

When the semiconductor substrate 101 is loaded on the pillar 103, as illustrated in Fig. 1C, the upper and lower supporting members 105A and 105B are bent toward the pillar by the manual operation. To prevent the semiconductor substrate 101, which is supported by both the upper and lower supporting members 105A and 105B, from being vibrated in the horizontal direction, a rubber 117 made of, for instance, a sillicone rubber for preventing the horizontal vibrations is employed between the upper supporting member 105A of the pillar 103 and the lower supporting member 105B.

It should be noted that the pillar 103 may be shaped as a cylinder according to the invention. In this case, it is apparent that the shape of the opening 102 formed on the semiconductor substrate 101 may be circle.

It should also be noted that both rear surfaces of two sheets of the semiconductor substrates 101, on which no integrated circuit 101A is arranged, are connected to each other by the adhesive agent, and thus the connected semiconductor substrates are sandwiched by these upper and lower supporting members 105A and 105B. In this case, an interval between the upper and lower supporting members 105A and 105B is wider than that of a single semiconductor substrate 105.

The following effects according to the first embodiment will be achieved.
(1). The packaging device according to the first embodiment is so constructed that the center portion of the above-described semiconductor substrate 101 is supported by the pillar 103 which passes through the center portion of the large-sized semiconductor substrate 101, and also by the upper and lower supporting members 105A and 105B mounted on the pillar 103. Accordingly, since the large-sized semiconductor substrate 101 can be supported in a stable condition, the packaging device for stably packaging the semiconductor substrate 101 can be obtained.
(2). Since the spring electrodes 115 are provided on the upper and lower supporting members 105A and 105B for sandwiching the semiconductor substrate 101, the semiconductor substrate 101 can be supported and simultaneously, the electrical connection can be established between the respective semiconductor substrates 101, and also between the semiconductor substrate 101 and the packaging substrate.
(3). As the connector pin 104 is mounted on the bottom of the pillar 103, the pillar 103 is packaged onto the packaging substrate and simultaneously, the electrical connection can be achieved.
(4). Since the center portion of the semiconductor substrate 101 is connected to the pillar 103, the maximum distance between this connection point and the arbitrary point on the circuit region 101A is substantially equal to a half of the diameter of the semiconductor wafer 101 so that a difference between the transferring speeds can be reduced.
(5). As the center portion of the semiconductor substrate 101 is supported, and no shielding part is present around the semiconductor substrate, the heat radiation effect can be improved.
(6). Since a plurality of semiconductor substrates 101 are mounted on the pillar 103 in such a way that these substrates are successively overlapped along the pillar 103, a large quantity of circuits can be arranged within a smaller packaging area.

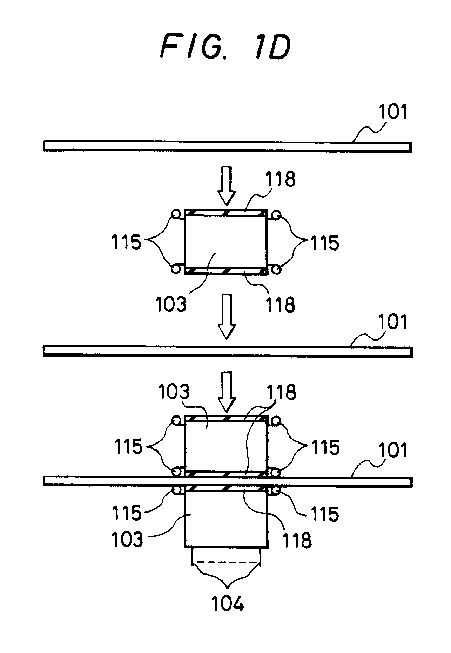

The packaging device according to the invention may be constructed as packaging device as shown in Fig. 1D.

In Fig. 1D, the semiconductor substrate 101 has no opening 102 as illustrated in Figs. 1A to 1C. The shape of the pillar 103 is formed as a rectanglar pillar or a cylindircal pillar, the upper and lower edges of which are flat surfaces. That is to say, an interior of the pillar 103 is formed as a cavity, and both the upper and lower ends thereof are made closed. The adhesive agent 118 is coated on both the upper and lower ends thereof are made closed. The adhesive agent 118 is coated on both the upper and lower ends which are in turn attached to the central portion of the semiconductor substrate 101. No integrated circuit is constructed on the portion to which the pillar 103 of the semiconductor substrate 101 is attached. Connecting electrodes (not shown) are employed on both surfaces of the semiconductor substrate 101, corresponding to the electrode 115 mounted on the pillar 103. Electrical connection is made between the electrodes formed on both surfaces of the semiconductor substrate 101 via the connecting hole which penetrates through the semiconductor substrate 101.

The pillar 103 and semiconductor substrate 101 are alternately stacked from the bottom.

The advantage achieved by the above-described first embodiment will now be summarized. That is to say, since the central portion of the semiconductor substrate is supported so as to construct the packaging device, and thus, the large-sized semiconductor substrate can be stably supported, the packaging device for packaging the large-sized semiconductor substrate in a stable condition can be realized.

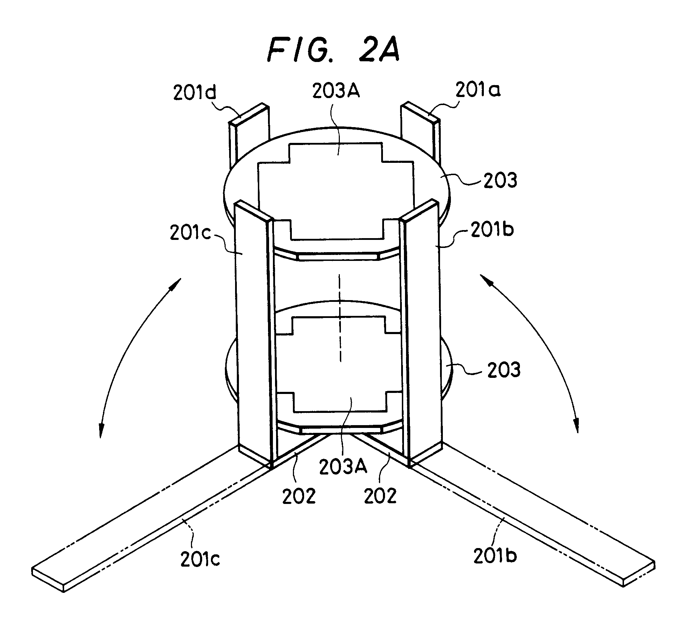

In Fig. 2A, reference numeral 203 denotes a semiconductor wafer made of a monocrystal silicon and reference numeral 203A indicates an integrated circuit region for constructing various integrated circuits.

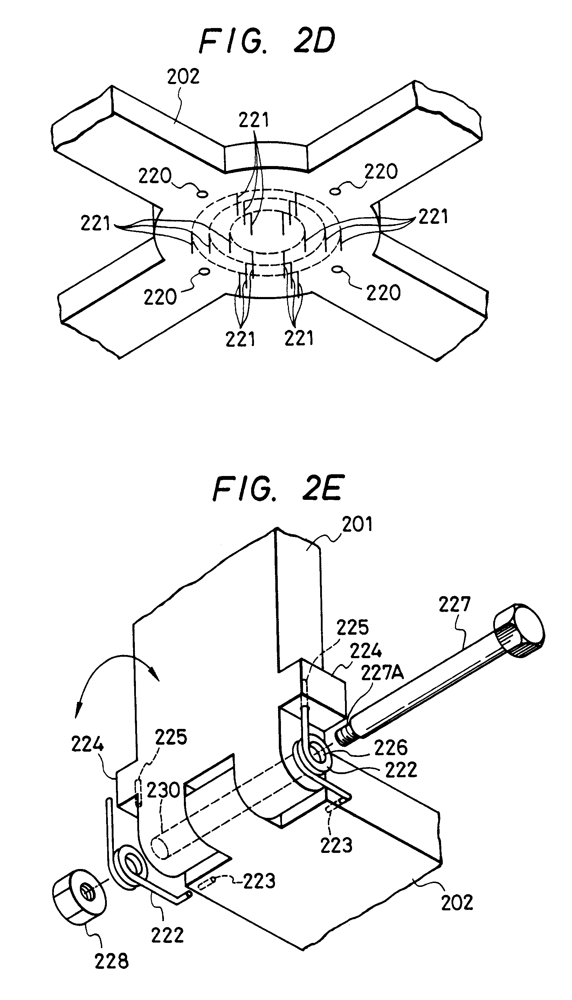

A packaging device of a semiconductor integrated circuit according to this second embodiment includes pillars 201a, 201b, 201c and 201d standing at a peripheral portion of an integrated wafer 203, and a pillar connecting substrate 202 which is connected to the lower end portions of these pillars 201a and 201d so as to stably stand these pillars. The pillar 201 and pillar connecting substrate 202 are made of a resin such as an epoxy resin, or aluminium. The semiconductor wafer 203 is sandwiched by semiconductor substrate supporting members 205 and 210 which are provided on the pillar 201. Among the above-described pillars 201a to 201d, the pillars, for instance, 201b and 201c are arranged to be bent, or brought down as shown in Fig. 2E. The remaining pillars 201a and 201d are fixed on the pillar connecting substrate 202. It should be noted that only the pillar 201a, three pillars 201a to 201c, or all of the pillars 201a to 201d may be bent or brought down. The pillars 201 other than the bendable pillars 201 are fixed on the pillar connecting substrate 202.

Then, a description will now be made of the portion for supporting the semiconductor wafer 203 of the pillar 201.

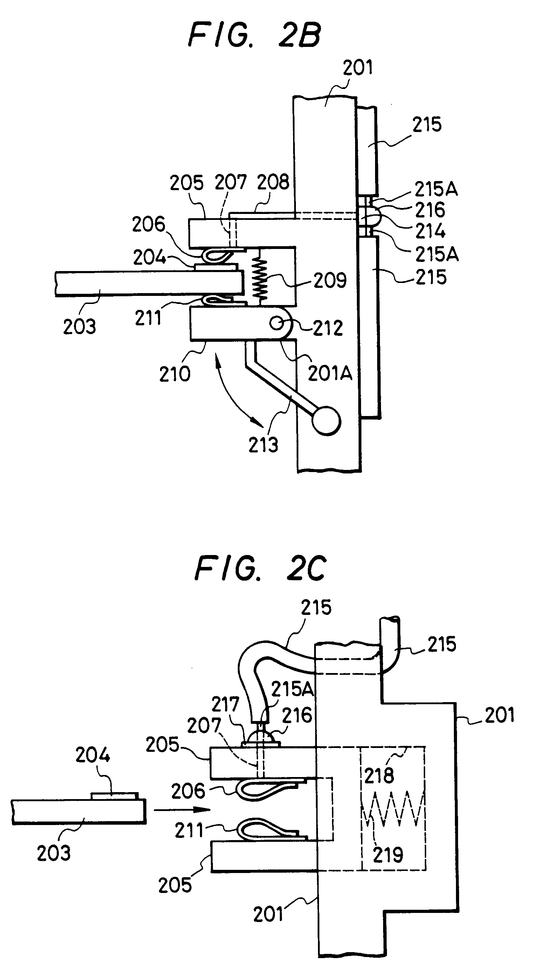

In Fig. 2B, the semiconductor wafer 203 is supported by the upper semiconductor substrate supporting member 205 and the lower semiconductor substrate supporting member 206 mounted on the pillar 201 in the fixed condition. The upper semiconductor substrate supporting member 210 is made of, for instance, a resin such as an epoxy resin, or alminium, and is integrally formed with, for example, the pillar 201. The lower semiconductor substrate supporting member 210 is mounted on a supporting section 201A projecting from the pillar 201 in such a manner that it is rotatable around the supporting shaft 212. The lower semiconductor substrate supporting member 210 is made of, for instance, a resin such as a glass epoxy resin, or aluminium. A plurality of hair-pin-shaped spring electrodes 206 are provided on the lower surface of the upper semiconductor substrate supporting member 205 so as to be resiliently connected to the electrode 204 of the semiconductor wafer 203. The spring electrode 206 is connected via an embeded wiring lead 207 which penetrates through the upper semiconductor substrate supporting member 205, and the upper wiring lead 208 of the upper surface of the upper semiconductor substrate supporting member 205, to a terminal electrode 214 provided on the outer wall of the pillar 201. The wiring lead 208 penetrates through a through hole formed on the pillar 201. To achieve the better contact between the lower semiconductor substrate supporting member 201 and the semiconductor wafer 203, the hair-pin-shaped pressure spring 211 is provided on the upper surface of the lower semiconductor substrate supporting member 210, i.e., the plane opposite to the semiconductor wafer 203. By connecting by the coil spring 209 between the upper semiconductor substrate supporting member 205 and the lower semiconductor substrate supporting member 210, both the force required for sandwiching the semiconductor wafer 203 by means of both the upper and lower semiconductor substrate supporting members 205 and 210, and also the force required for connecting the spring electrode 206 to the electrode 204 of the semiconductor wafer 203. The portion on which the coil spring 209 of the lower semiconductor substrate supporting member 210 is located at the side of the semiconductor wafer 203 rather than the supporting axis 212. A handle 213 is mounted on the lower surface of the lower semiconductor substrate supporting member 210 so as to open a space defined between the upper and lower semiconductor substrate supporting members 205 and 210 when mounting the semiconductor wafer 203. The above-described upper semiconductor substrate supporting member 205, lower semiconductor substrate supporting member 210, and coil spring 209 are mounted on the corresponding pillars 201a, 201b, 201c and 201d, so that the semiconductor wafer 203 can be sandwiched at four positions under the stable condition. Furthermore, the above-described spring electrode 206, wiring leads 207 and 208, coil spring 209 and pressure spring 211 are mounted on the respective upper and lower substrate supporting members 205 and 210 which are mounted on the corresponding four pillars 201. With respect to the spring electrode 206, the electrode 204 is arranged to the semiconductor wafer 203.

To the terminal electrode 214 at the outer wall of the pillar 201, a core 215A of a cable 215 which is insulating-covered with vinyle chloride is connected by solder. This insulating cable 215 connects the respective semiconductor wafers 203, and the semiconductor wafers 203 packaged on the packaging substrate and also the wiring lines on the packaging substrate.

A sandwiching member of the semiconductor wafer 203, as illustrated in Fig. 2C, is provided in such a manner that the semiconductor wafer supporting, or sandwiching member 205 is ⊐-shaped, and both the spring electrode 206 and pressure spring 211 are fixed on the side surface of the inside thereof. The pillar 201 defines a cavity 218 of a cylindrical form at the portion corresponding to the semiconductor substrate supporting member 205 in order to fit with the semiconductor substrate supporting member 205. The semiconductor substrate supporting member 205 fitted within this cavity 218 is positioned to be depressed by the coil spring 219. A terminal electrode 217 is provided on the upper surface of the semiconductor substrate supporting member 205, to which the core 215A of the cable 215 is connected. The cable 215 extends over the plane opposite to the semiconductor wafer 203, i.e., the outer wall of the pillar 201. This cable 215 is connected via a through hole formed on the pillar 201 adjacent to the semiconductor substrate supporting member 215 to the terminal electrode 216. To achieve the better connection between the spring electrode 206 and the electrode 204 and also firmly sandwich the semiconductor wafer 203, an interval between the spring electrode 206 and pressure spring 211 by which the semiconductor wafer 203 is not yet mounted, is narrower than the thickness of the semiconductor wafer 203.

As illustrated in Fig. 2D, a plurality of connector pins 221 connected to the cable 215, as illustrated in Fig. 2B or 2C, are provided on the bottom of the pillar connecting substrate 202. These connector pins 221 are connected to the connector for the packaging substrate. Since the pillar connecting substrate 202 is mounted to the packaging substrate by screws during the packaging operation, a plurality of screw holes 220 are formed.

One example of the connection between the lower end portion of the pillar 201 and the pillar connecting substrate 202 is shown in Fig. 2E. As shown in Fig. 2E, the connecting portion of the pillar connecting substrate 202 is engaged with the lower portion of the pillar 201, and rotatably connected in such a manner that a mounting bolt 227 is inserted into the corresponding bolt hole 230 formed on these portions. The bolt 227 is so arranged that it is not dropped from the corresponding bolt hole 230 by mounting a nut 228 on the screw section 227. A twist coil spring 222 is positioned on both sides of the pillar and the bolt 227 is penetrated through the respective center holes 226. One end of this twist coil spring 222 is mounted in the spring mounting hole 223 of the pillar connecting substrate 202, whereas the other end thereof is mounted in the spring mounting hole 225 formed on the projecting 224 of the pillar 201. The pillar 201 can be stood up at a right angle by this twist coil spring 222, and also the bent pillar 201 can be recovered by means of the twist coil spring 222.

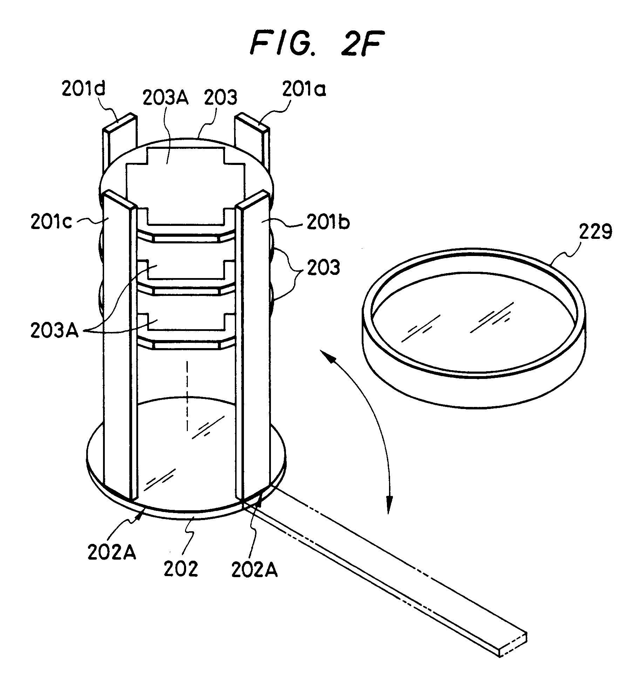

It should be noted that both the pillar 201 and pillar connecting substrate 202 may be constructed as shown in Fig. 2F.

In Fig. 2F, one pillar 201b among four pillars 201 is so arranged to be bent. A hinge is mounted between the bent pillar 201b and the pillar connecting substrate 202 at these connecting sections 202A in such a manner that it is mounted between the outer wall of the pillar 201 and the edge portion of the pillar connecting substrate 202. Since the hinge is mounted to the outer wall of the pillar 201b, the pillar is not bent inside, but allowable to be bent outside. In order to prevent the standing pillar 201b from being bent inside, a lid 229 is employed to cover it. Also the semiconductor substrate supporting members 205 shown in Fig. 2B or 2C and 210 are provided with the pillar 201 illustrated in Fig. 2F.

The following various merits can be achieved according to the above-described packaging device of this second embodiment.
(1). The packaging device is constructed of a plurality of pillars 201 which stand at the peripheral portion of the semiconductor wafer 1, the semiconductor substrate supporting members 205 or 210 provided thereon, and the pillar connecting substrate 202. As a result, the semiconductor wafer 203 can be supported without twist and vibrations, so that a large-sized semiconductor integrated circuit constructed of the semiconductor wafer 203 can be packaged in the stable condition.
(2) Since the connector pin 221 is mounted on the bottom of the pillar connecting substrate 202, the integrated circuits can be connected to the packaging substrate in such a manner that the stable supporting condition for the semiconductor wafer 203 is not disturbed, in other words, the semiconductor wafer 203 is not bent.
(3). The spring electrode 206 is provided on the semiconductor substrate supporting member 205, with the result that both the semiconductor wafer 203 can be sandwiched and simultaneously the electrical connection can be realized.
(4). As the electrode mounted on the semiconductor substrate supporting member 205 is used as the spring electrode 206, the sandwich effect by the semiconductor wafer 203 can be improved so as to electrically connect the corresponding portions.
(5). Since the twist coil spring 222 or lid 229 for standing the pillar 203 is employed, the pillar 201 may not be bent while supporting the semiconductor wafer 203, so that the stable supporting condition of the semiconductor wafer 203 can be maintained for a long time.
(6). A plurality of semiconductor wafers 203 can be mounted on the pillar 201, with the result that a large circuit system can be arranged with a smaller packaging area.
(7). Since the pillar 203 can be bent, the substrate wafer 203 can be mounted in the horizontal direction while bending the pillar 203. As a result, the semiconductor wafer 203 can be easily mounted.

While the present invention has been described using a specific embodiment, it should be noted that further modifications and changes can be made without departing from the scope of the present invention.

Both the rear surfaces of the semiconductor wafer 203, for instance, are attached to each other, and the resultant semiconductor wafers 203 may be supported by either the semiconductor substrate supporting members 205 and 210 (see Fig. 2B), or 205 (Fig. 2C). In this case, the interval between the semiconductor supporting members 205, 210, and 205, into which the semiconductor wafer 203 can be inserted, is made wider than that of the single semiconductor wafer 203.

Also, the semiconductor wafer 203 is not limited to the above-mentioned wafer, but may be such a semiconductor substrate that, for example, the peripherals of the semiconductor wafer 203 are cut off to form a rectangle-shaped semiconductor wafer. In this case, the layout for arranging the respective pillars 201, and the size and shape of the pillar connecting substrate 202 may be modified, depending upon the size and shape of the employed semiconductor substrate.

The advantage achieved by the above-mentioned second embodiment will now be briefly described.

That is to say, since the packaging device is constructed of a plurality of pillars standing around the peripherals of the semiconductor wafer, the semiconductor substrate supporting members and pillar connecting members and pillar connecting substrate mounted thereto, the semiconductor wafer can be supported thereon without any twist and vibration phenomenon. As a consequence, a large-sized semiconductor integrated circuit constructed of a semiconductor wafer can be packaged under the stable condition.

## Claims

1. A stack of large sized semiconductor substrates, comprising a packaging device with a plurality of engaging means, each engaging means being for engaging a respective one of the substrates to maintain the substrates in spaced apart relationship, characterised in that:
the engaging means including means for providing a plurality of independent electrical connections to the substrate.

2. A stack according to claim 1, wherein the packaging device engages the substrates at a central part of those substrates.

3. A stack according to claim 2, wherein each substrate has an opening at a central part thereof, and the packaging device comprises an elongate pillar extending through those openings and engaging each substrate at or adjacent the opening.

4. A stack according to claim 1, wherein the packaging device comprises a plurality of interconnected pillars each having means for engaging the substrates at the periphery of those substrates.

5. A stack according to claim 4, wherein the pillars are interconnected by a base, and the pillars are hinged to that base.

6. A stack according to claim 5, wherein the pillars are hinged to the base via a spring, biasing the pillars into engagement with the substrates.

7. A stack according to any one of the preceding claims, wherein the packaging device has means for making electrical contact with each substrate.

8. A stack according to claim 7, wherein the means for making connection is a spring electrode.

## Patentansprüche

1. Stapel groß bemessener Halbleitersubstrate, mit einer Montagevorrichtung mit einer Vielzahl von Eingriffseinrichtungen, wobei jede Eingriffseinrichtung zum Eingriff in jeweils ein einzelnes der Substrate eingerichtet ist, um die Substrate in gegenseitigem Abstand zuhalten, dadurch **gekennzeichnet,** daß die Eingriffseinrichtung eine Einrichtung zum Herstellen einer Vielzahl unabhängiger elektrischer Anschlüsse an das Substrat umfaßt.

2. Stapel nach Anspruch 1, worin die Montagevorrichtung in die Substrate an einem mittigen Teil dieser Substrate eingreift.

3. Stapel nach Anspruch 2, worin jedes Substrat eine Öffnung an seinem mittigen Teil aufweist und die Montageeinrichtung eine längliche Säule aufweist, die sich durch diese Öffnungen erstreckt und in jedes Substrat an oder nahe der Öffnung eingreift.

4. Stapel nach Anspruch 1, worin die Montagevorrichtung eine Vielzahl miteinander verbundener Säulen aufweist, von denen jede eine Einrichtung zum Eingriff in die Substrate am Umfang dieser Substrate aufweist.

5. Stapel nach Anspruch 4, worin die Säulen miteinander durch einen Sockel verbunden sind und die Säulen an diesem Sockel gelenkig angebracht sind.

6. Stapel nach Anspruch 5, worin die Säulen am Sockel über eine Feder gelenkig angebracht sind, die die Säulen in Richtung des Eingriffs mit den Substraten belastet.

7. Stapel nach irgendeinem der vorangehenden Ansprüche, worin die Montagevorrichtung eine Einrichtung zum Herstellen eines elektrischen Kontakts mit jedem Substrat aufweist.

8. Stapel nach Anspruch 7, worin die Einrichtung zum Herstellen eines Kontakts eine Federelektrode ist.

## Revendications

1. Empilage de substrats semiconducteurs de grande taille, comprenant un dispositif de conditionnement comportant une pluralité de moyens d'engagement, chacun des moyens d'engagement étant destiné à s'appliquer contre l'un respectif des substrats pour maintenir les substrats réciproquement espacés, caractérisé en ce que
les moyens d'engagement comprennent des moyens servant à établir une pluralité de connexions électriques indépendantes avec le substrat.

2. Empilage selon la revendication 1, dans lequel le dispositif de conditionnement s'applique contre les substrats au niveau d'une partie centrale de ces derniers.

3. Empilage selon la revendication 2, dans lequel chaque substrat possède une ouverture dans sa partie centrale, et le dispositif de conditionnement comprend une colonne allongée qui traverse ces ouvertures et engrène avec chaque substrat au niveau ou au voisinage de l'ouverture.

4. Empilage selon la revendication 1, dans lequel le dispositif d'emballage comprend une pluralité de colonnes interconnectées comportant chacune des moyens pour engrener avec les substrats au niveau de la périphérie de ces substrat.

5. Empilage selon la revendication 4, dans lequel les colonnes sont interconnectées par une base et sont articulées à cette base.

6. Empilage selon la revendication 5, dans lequel les colonnes sont articulées à la base par l'intermédiaire d'un ressort, qui sollicite les colonnes de manière qu'elles engrènent avec les substrats.

7. Empilage selon l'une quelconque des revendications précédentes, dans lequel le dispositif de conditionnement comporte des moyens pour établir un contact électrique avec chaque substrat.

8. Empilage selon la revendication 7, dans lequel les moyens pour établir une connexion sont formés par un ressort-électrode.
